# EUROPEAN PATENT SPECIFICATION

(11) **EP 3 174 088 B1**
(45) Date of publication and mention of the grant of the patent: **30.12.2020**
(21) Application number: 16200470.9
(22) Date of filing: 24.11.2016
(51) Int. Cl.: H01L 21/56, H01L 23/495, H01L 23/31, H05K 3/34

(54) **METHOD OF MANUFACTURING A PLASTIC PACKAGED SMD DIODE**
VERFAHREN ZUR HERSTELLUNG EINER SMD-DIODE MIT KUNSTSTOFFGEHÄUSE
PROCÉDÉ DE FABRICATION D'UNE DIODE DE TYPE CMS EMBALLÉE EN PLASTIQUE

(30) Priority: 26.11.2015 CN 201510836602; 26.11.2015 CN 201520955973 U
(43) Date of publication of application: 31.05.2017
(73) Proprietor: Siyang Grande Electronics Co., Ltd., Suqian 223700, Jiangsu (CN)
(72) Inventor: ZHONG, Yunhui, SUQIAN 223733, JIANGSU (CN)
(74) Representative: EP&C

(56) References cited:
- CN-A- 1 976 077
- US-A- 3 426 423
- US-A- 4 763 599
- US-A- 5 236 117
- US-A- 6 085 396
- US-A1- 2001 015 486
- US-A1- 2002 113 301
- US-A1- 2013 005 087

## Description

### FIELD OF THE INVENTION

The present invention belongs to the technical field of semiconductor electronic components, and specifically relates to a surface-mounted device, SMD, diode taking a runner as the body and the manufacturing method thereof.

### BACKGROUND OF THE INVENTION

Among the numerous semiconductor electronic components, an SMD diode is a basic component and widely used in various fields. The main existing production process of the SMD diode is as follows: Chip test → assembling with a lead frame → sintering → pickling → sizing → baking → plastic packaging → postcuring → waste removing → flattening → cutting ribs and molding → electroplating → printing test → external inspection → packaging → QA inspection → storage, wherein the main step in the electroplating process is electroplating the positive and negative pins of the diode with tin, with the tinned layer on the positive and negative pins being a plane layer. In soldering with the circuit board, the process is troublesome and time-consuming, and the production process of the tinned layer may emit a large amount of toxic and harmful gases, waste water and metal ions, which are prone to causing environmental pollution and harming the health of staff.

In the electronics industry, a diode has become the basic component of a variety of electronic products. A traditional diode product is provided at both ends with a lead, and needs a hole to be drilled in the circuit board to allow the lead to go there through so that the product is fixed on the circuit board. However, the electronic products currently used around the world, such as telephones, television sets, fax machines, computers and peripheral products, are researched and developed to be thinner and shorter, with the double-layer or multi-layer circuit board technology widely used in the circuit board technology. Since the double-layer or multi-layer circuit board cannot be drilled to have a hole in it, all the circuit boards with two and more layers use an SMD electronic component. For example, SMD resistors have mostly replaced the shaft drive resistors due to low production costs.

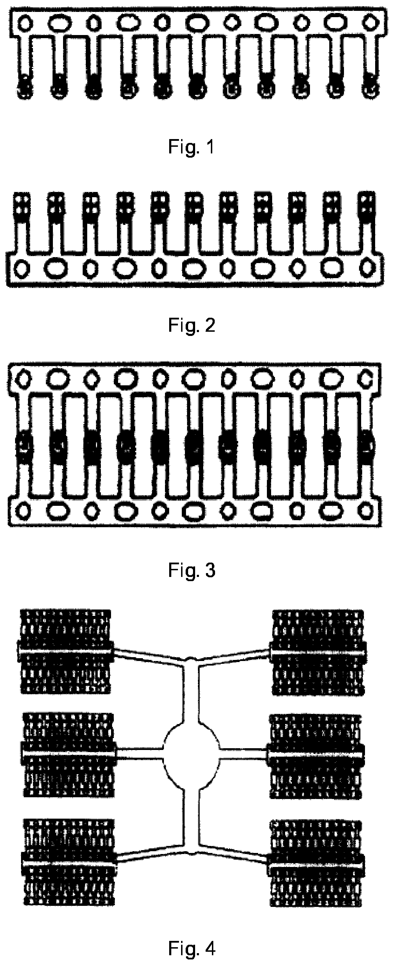

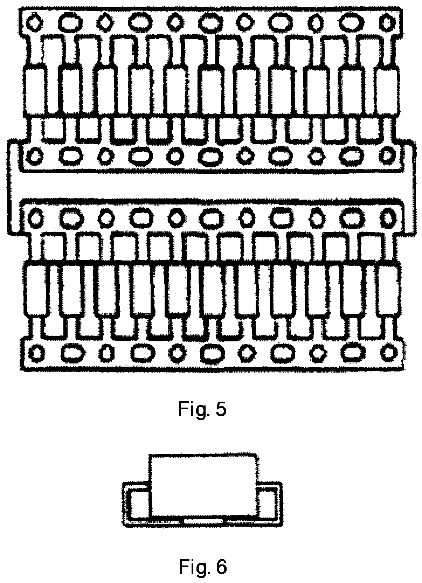

The main current production method of the SMD diode, as shown in Figs. 1 to 6, is as follows: First, making the copper sheet into what is as shown in Figs. 1 and 2, and using what is as shown in Fig. 1 as the lower layer; then, placing a solder sheet or solder paste to the end of each copper sheet in Fig. 1, and placing the diode chip onto the solder paste; next, placing a solder sheet or solder paste onto the chip, and stacking what is as shown in Fig. 2 onto the solder paste; next, soldering with a high-temperature furnace to obtain what is as shown in Fig. 3; next, molding with a high-temperature mold and epoxy resin to obtain what is as shown in Fig. 4; next, blanking into what is as shown in Fig. 5; and finally, cutting, bending, and electroplating to obtain what is as shown in Fig. 6.

This production process, as the existing mainstream way of producing the SMD diodes, has the following shortcomings:
(1) The mold occupies a large space, and has poor molding efficiency;
(2) with the copper sheets on both sides having to be cut off, the utilization rate of copper is 10-15%, which wastes copper while increases production costs;
(3) while molding, the epoxy resin has to go through the middle runner before being ejected toward both sides, which wastes the runner and may make the epoxy resin injected into the diode ducts on both sides, with the utilization rate of the epoxy resin less than 30%; because epoxy resin cannot be recycled, environmental pollution is also easy to be caused; and
(4) the molded SMD diode is a single-chip SMD diode after being cut; afterwards the copper pin of each SMD diode requires to be electroplated with tin, which has low production efficiency; besides, in the production process of electroplating tin, a large amount of toxic and harmful gases, waste water and metal ions will be emitted, which is prone to causing environmental pollution and harming the health of staff.

US 2002/0113301 A discloses a package for semiconductor. It comprises four major related parts: semiconductor chips, solder layer, conductive element, and encapsulation body, especially refer to a leadless DIP (dual-in-line package) or SIP (single-in-line package). The conductive elements and bonding contacts are part of the lead frame. Each of the conductive elements is composed of three connected portions, including terminal, bridging lead and bonding contact(s). A connecting bridge is made in between each two terminals. Thus all conductive elements are linked and associated to the frame of the lead frame and the master strip. Solder paste is applied, and semiconductor chip(s) is/are attached. The unit is formed into U shape and the upper contact(s) are made to attach to the bonding pad(s) of semiconductor(s). The solder paste is re-flown to form solid joints. Tape is adhered to seal the openings in between terminals. The in-line units thus form a subassembly piece with a U-shape-like trough.

US6085396 A discloses a manufacturing method for rectifying diodes, wherein a plurality of upper and lower pins are combined with a plurality of electronic chips to form a coarse blank. The rectifying diodes are processed to form shaped insulating layers by molding. Each insulating layer is processed to have superficial coarseness having micro-protuberances thereon; the areas on both the lateral sides of the insulating layer are applied with electric conductive layer. The electric conductive layer is combined with the insulating layer; they are equidistantly cut with a knife into shaped rectifying diodes. The shaped rectifying diodes each is further electrically plated with a further layer of electric conductive material on both sides of the electric conductive layer to form a harder protection layer, and then finished rectifying diodes are obtained. The upper and lower pins are in the form of thin sheets, plus the small chips, the shaped rectifying diodes have small volumes.

US 2001/015486 A1 discloses a semiconductor device provided with a first one-piece lead, a semiconductor chip mounted on the first lead, a second one-piece lead connected to the chip, and a resin package for enclosing the semiconductor chip together with a part of each lead. The second lead includes a flexible end connected to the chip by a conductive material. This flexible end is smaller in width than the remaining portion of the second lead.

### SUMMARY OF THE INVENTION

A purpose of the present invention is to provide an SMD diode, which has a simple structure, is easier to be soldered to the circuit board, and improves the production efficiency, and a method of manufacturing the SMD diode taking a runner as the body, which can not only save copper and epoxy resin and reduce the space occupied by the mold, but also have improved production efficiency and environmental protection effect by first dipping the copper pin into tin and then cutting.

A method of manufacturing the SMD diodes is provided, comprising the steps set out in claim 1.

In a preferred technical solution, the plastic-packaging material is epoxy resin.

In a preferred technical solution, after cutting is finished the upper and lower surfaces of the plastic-packaged body of the single-chip SMD diode are smooth, while the surfaces of both sides of the copper pin are rough.

In a preferred technical solution, the positive and negative pins are provided with a tin solder layer at the junction with the chip.

In a preferred technical solution, the external shape of the plastic-packaged body is rectangular.

In use, the SMD diode manufactured in accordance with the method of the present invention is affixed to the circuit board, and thus the positive and negative pins can be directly soldered to the circuit on the circuit board.

The method of the present invention has the following advantages:
1. The tin-dipped layer having a cambered surface is naturally formed under the surface tension effect of the tin liquid during the tin-dipping process of the positive and negative pins; when soldered to a circuit board, the positive and negative pins with an arc are easier to be soldered successfully to the circuit board, which not only improves the production efficiency, but also basically produces no toxic and harmful gases, waste water or metal ions during the tin-dipping process compared to the tin electroplating process, thus being of environmental protection and less likely to harm the health of staff;
2. A copper pin is adopted for soldering directly, with the utilization rate of copper reaching 100 percent, greatly reducing the use cost of copper;
3. An elongated runner groove is adopted to cure and package the diode chips arranged side by side and the corresponding copper pins thereon, with the utilization rate of epoxy resin up to 90% or more, thus reducing the use cost of epoxy resin while reducing environmental pollution;
4. The tin-dipping of the copper pins instead of the traditional tin-electroplating results in a tin-dipped layer having a cambered surface formed on the part of the copper pin extending out of the plastic-packaged body under the surface tension effect of the tin liquid; when soldered to a circuit board, the copper pin with an arc is easier to be soldered to the circuit board successfully, which not only improves the production efficiency, but also basically produces no toxic and harmful gases, waste water or metal ions during the tin-dipping process compared to the tin electroplating process, thus being of environmental protection and less likely to harm the health of staff.

### BRIEF DESCRIPTION OF THE DRAWINGS

The present invention will be further described below with reference to drawings and examples:
Figs. 1 to 6 are schematic views showing a current method of manufacturing an SMD diode;
Fig. 7 is a schematic view showing the structure of a mold used in the present invention;
Fig. 8 is a schematic view showing the structure of an SMD diode assembly;
Fig. 9 is a schematic view showing the structure of an SMD diode obtained by the present invention;
Fig. 10 is a sectional view showing the structure of an SMD diode obtained by the present invention;
   wherein: 1. a chip; 2. a positive pin; 3. a negative pin; 4. a plastic-packaged body; 5. a tin-dipped layer; and 6. a tin solder layer.

### DETAILED DESCRIPTION OF THE EMBODIMENTS

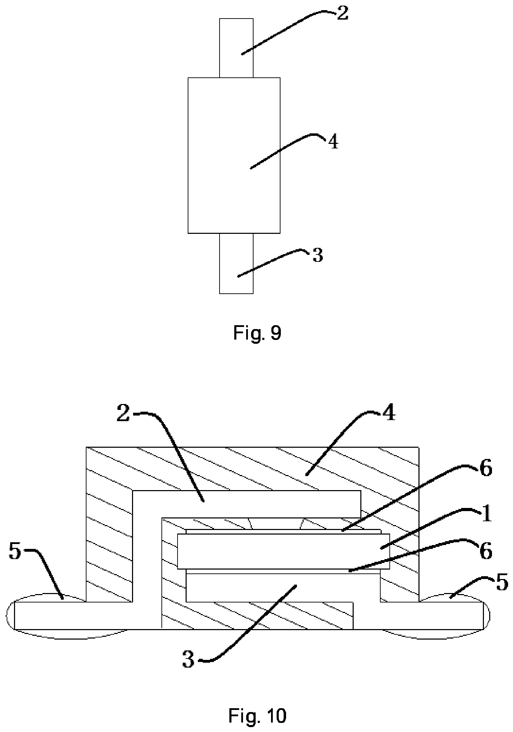

Example: As shown in Fig. 10, an SMD diode taking a runner as the body is provided, comprising a chip 1, a positive pin 2 and a negative pin 3 connected respectively with the upper and lower surfaces of the chip 1, and a plastic-enclosed body 4 wrapped on the outside of the chip 1; both the positive pin 2 and the negative pin 3, after bent twice, extend out of the bottom of the plastic-enclosed body 4 to the outside of the plastic-enclosed body 4 in two opposite directions, and are provided on the part extending out of the plastic-packaged body 4 with a tin-dipped layer 5 having a cambered surface.

Both the positive pin 2 and the negative pin 3 are provided with a sheet copper pin bent twice at an angle of 90°. The positive pin 2 and the negative pin 3 are provided with a tin solder layer 6 at the junction with the chip 1, and the external shape of the plastic-packaged body 4 is rectangular.

While in use, the SMD diode obtained by the present invention is affixed to the circuit board, and thus the positive pin 2 and the negative pin 3 can be directly soldered to the circuit on the circuit board. This tin-dipped layer 5 on the positive pin 2 and the negative pin 3 is naturally formed under the surface tension effect of the tin liquid during the tin-dipping process of the positive pin 2 and the negative pin 3, When soldered to a circuit board, the positive pin 2 and the negative pin 3 with an arc are easier to be soldered successfully to the circuit board, which not only improves the production efficiency, but also basically produces no toxic and harmful gases, waste water or metal ions during the tin-dipping process compared to the tin electroplating process, thus being of environmental protection and less likely to harm the health of staff.

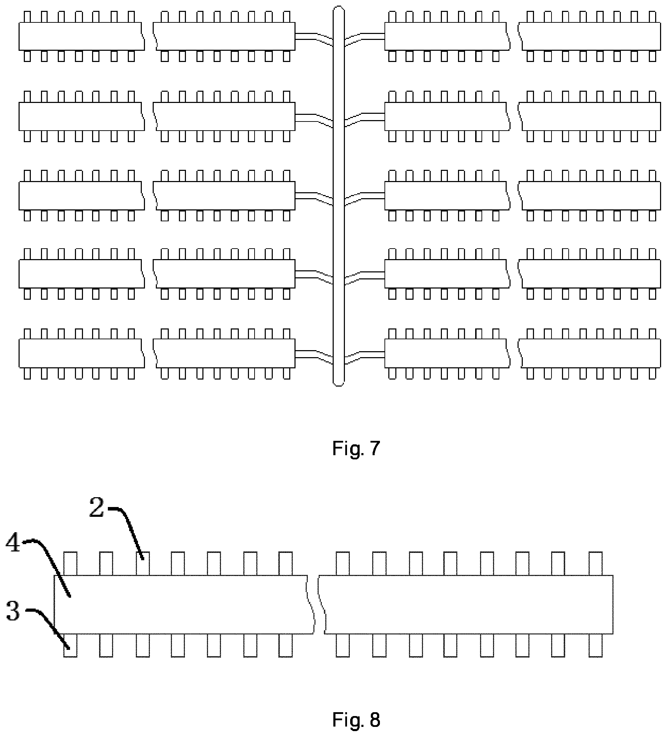

As shown in Fig. 8, a passive electronic component is provided, comprising multiple SMD diodes arranged in turn side by side, with the plastic-packaged bodies 4 of the adjacent SMD diodes integrally molded. Before being used, the SMD diode assembly is cut into multiple single-chip SMD diodes in the cutting process, and therefore the upper and lower surfaces of the plastic-packaged body 4 are smooth, and the surfaces of both sides of the positive pin 2 and the negative pin 3, i.e., the face of cut, are rough; then the single-chip SMD diode is affixed to the circuit board, and thus the positive pin 2 and the negative pin 3 can be directly soldered to the circuit on the circuit board. This electronic component has not only a simple structure but also a simple process and high production efficiency, with the plastic-packaging materials and copper having high utilization rate and reduced production costs in the production process.

As shown in Figs. 7 to 10, a method of manufacturing the SMD diode taking a runner as the body is provided, specifically comprising the following steps:
Step (1) soldering: soldering multiple groups of the diode chips and the corresponding copper pins thereon simultaneously, wherein this group of the diode chips is composed of one diode chip 1, which is soldered correspondingly to two copper pins (the positive pin 2 and the negative pin 3) that are a sheet copper pin bent twice at an angle of 90°;
step (2) packaging and molding: placing the multiple soldered diode chips and the corresponding copper pins thereon side by side into an elongated runner groove of an injection mold, and then injecting a plastic-packaging material into the elongated runner groove, and curing and packaging the multiple diode chips and the corresponding copper pins thereon simultaneously, thus obtaining a plastic-packaged body 4 of the multiple diode chips and the copper pins thereon;
step (3) tin dipping: taking out the above plastic-packaged body with the built-in multiple diode chips and the copper pins thereon, and dipping the part of the copper pins extending out of the plastic-packaged body 4 into tin; after completing tin dipping, a tin-dipped layer 5 having a cambered surface is formed on the part of the copper pin extending out of the plastic-packaged body 4 under the surface tension effect of the tin liquid;
step (4) cutting: cutting the above plastic-packaged body 4 with the built-in multiple diode chips and the copper pins thereon in turn into multiple single-chip SMD diodes, and therefore the upper and lower surfaces of the plastic-packaged body 4 of the single-chip SMD diode are smooth, while the surfaces of both sides of the copper pin, i.e., the face of cut, are rough; and
step (5) testing and packaging: testing and packaging the single-chip SMD diodes in turn.

The above examples only illustrate the principle and effect of the present invention, instead of limiting the present invention. Those skilled in the art can make modifications and variations to the above examples without departing from the scope of the present invention. Therefore, it is intended that the appended claims of the present invention cover all the equivalent modifications and variations made by those of ordinary skill in the art.

## Claims

1. A method of manufacturing surface-mounted device, SMD, diodes, comprising the following steps:
(1): soldering multiple diode chips (1) and corresponding copper pins thereon simultaneously, the copper pins comprising a positive pin (2) and a negative pin (3) connected respectively with the upper and lower surfaces of the chip (1), wherein each copper pin in step (1) is a sheet copper pin bent twice at an angle of 90°;
(2): placing the multiple soldered diode chips and the corresponding copper pins thereon side by side into an elongated runner groove of an injection mold, and then injecting a plastic-packaging material into the elongated runner groove, and curing and packaging the multiple diode chips and the corresponding copper pins thereon simultaneously, thus obtaining a plastic-packaged body (4) comprising the multiple diode chips and the copper pins thereon extending out of the bottom of the plastic-packaged body (4) in two opposite directions;
(3): taking out the plastic-packaged body with the multiple diode chips and the copper pins thereon, and dipping the part of the copper pins extending out of the plastic-packaged body into liquid tin, wherein after the tin dipping is finished, a tin-dipped layer (5) having a cambered surface is formed on the part of the copper pin extending out of the plastic-packaged body due to the surface tension of the tin liquid;
(4): cutting the plastic-packaged body with the multiple diode chips and the copper pins thereon in turn into multiple single-chip SMD diodes; and
(5): testing and packaging the single-chip SMD diodes in turn.

2. The method of manufacturing SMD diodes according to claim 1, wherein the plastic-packaging material in step (2) is epoxy resin.

3. The method according to claim 1, wherein the positive pin (2) and the negative pin (3) are provided with a tin solder layer (6) at the junction with the chip (1).

4. The method according to claim 1, wherein the external shape of the plastic-packaged body (4) is rectangular.

## Patentansprüche

1. Verfahren zur Herstellung von SMD (Surface Mounted Device, oberflächenmontiertes Bauelement)-Dioden, das die folgenden Schritte umfasst:
(1): gleichzeitiges Auflöten mehrerer Diodenchips (1) und zugehöriger Kupferstifte darauf, wobei die Kupferstifte einen positiven Stift (2) und einen negativen Stift (3) umfassen, die jeweils mit der oberen und der unteren Oberfläche des Chips (1) verbunden sind, wobei jeder Kupferstift in Schritt (1) ein Kupferblech-Stift ist, der zweimal in einem Winkel von 90° gebogen ist;
(2): Anordnen der mehreren gelöteten Diodenchips und der zugehörigen Kupferstifte darauf nebeneinander in einer längliche Laufrille einer Spritzgußform, und dann Einspritzen eines Kunststoff-Packmaterials in die längliche Laufrille, und gleichzeitiges Aushärten und Packen der mehreren Diodenchips und der zugehörigen Kupferstifte darauf, wodurch ein in Kunststoff verpackter Körper (4) erhalten wird, der die mehreren Diodenchips und die zugehörigen Kupferstifte darauf, die sich aus dem Boden des in Kunststoff verpackten Körpers (4) in zwei entgegengesetzten Richtungen heraus erstrecken, umfasst;
(3): Herausnehmen des in Kunststoff verpackten Körpers mit den mehreren Diodenchips und den Kupferstiften darauf, und Eintauchen des Teils der Kupferstifte, der sich aus dem in Kunststoff verpackten Körper heraus erstreckt, in flüssiges Zinn, wobei, nachdem das Tauchen in Zinn beendet ist, eine in Zinn getauchte Schicht (5), die eine gewölbte Oberfläche aufweist, auf dem Teil des Kupferstifts, der sich aus dem in Kunststoff verpackten Körper heraus erstreckt, aufgrund der Oberflächenspannung des flüssigen Zinns gebildet ist;
(4): Schneiden des in Kunststoff verpackten Körpers mit den mehreren Diodenchips und den Kupferstiften darauf der Reihe nach in mehrere Einzelchip-SMD-Dioden; und
(5): abwechselndes Testen und Verpacken der Einzelchip-SMD-Dioden.

2. Verfahren zur Herstellung von SMD-Dioden nach Anspruch 1, wobei das Kunststoff-Verpackungsmaterial in Schritt (2) Epoxidharz ist.

3. Verfahren nach Anspruch 1, wobei der positive Stift (2) und der negative Stift (3) an der Verbindungsstelle mit dem Chip (1) mit einer Zinnlötschicht (6) versehen sind.

4. Verfahren nach Anspruch 1, wobei die äußere Form des in Kunststoff verpackten Körpers (4) rechteckig ist.

## Revendications

1. Procédé de fabrication de diodes de dispositif monté en surface, CMS, comprenant les étapes suivantes consistant à :
(1) : souder simultanément plusieurs puces de diode (1) et des broches de cuivre correspondantes sur celles-ci, les broches de cuivre comprenant une broche positive (2) et une broche négative (3) connectées respectivement aux surfaces supérieure et inférieure de la puce (1), dans lequel chaque broche de cuivre à l'étape (1) est une broche de cuivre en feuille pliée deux fois sur un angle de 90°;
(2) : placer les multiples puces de diode soudées et les broches de cuivre correspondantes sur celles-ci côte à côte dans une rainure de canal allongée d'un moule d'injection, puis injecter un matériau de conditionnement en plastique dans la rainure de canal allongée, et durcir et conditionner les multiples puces de diode et les broches de cuivre correspondantes sur celles-ci simultanément, en obtenant ainsi un corps conditionné sous plastique (4) comprenant les multiples puces de diode et les broches de cuivre sur celles-ci s'étendant à l'extérieur du fond du corps conditionné sous plastique (4) dans deux directions opposées ;
(3) : retirer le corps conditionné sous plastique avec les multiples puces de diode et les broches de cuivre sur celles-ci, et immerger la partie des broches de cuivre s'étendant à l'extérieur du corps conditionné sous plastique dans de l'étain liquide, dans lequel, une fois l'immersion dans de l'étain terminée, une couche étamée (5) ayant une surface cambrée est formée sur la partie de la broche de cuivre s'étendant à l'extérieur du corps conditionné sous plastique en raison de la tension superficielle du liquide d'étain ;
(4) : découper le corps conditionné sous plastique avec les multiples puces de diode et les broches de cuivre sur celles-ci à leur tour en plusieurs diodes CMS monopuce ; et
(5) : tester et conditionner à leur tour les diodes CMS monopuce.

2. Procédé de fabrication de diodes CMS selon la revendication 1, dans lequel le matériau de conditionnement sous plastique de l'étape (2) est une résine époxy.

3. Procédé selon la revendication 1, dans lequel la broche positive (2) et la broche négative (3) sont pourvues d'une couche de soudure à l'étain (6) à la jonction avec la puce (1).

4. Procédé selon la revendication 1, dans lequel la forme externe du corps conditionné sous plastique (4) est rectangulaire.
